# EUROPEAN PATENT APPLICATION

(11) **EP 2 778 833 A1**
(43) Date of publication of application: **17.09.2014**
(21) Application number: 13001301.4
(22) Date of filing: 14.03.2013
(51) Int. Cl.: G06F 1/18, H01R 13/514, H05K 5/00, H05K 5/02

(54) **Modular expandable electronic device structure against intrusion of foreign object**

(71) Applicant: Chang, Lerng-Horng, Neihu Dist Taipei City 11493 (TW)
(72) Inventor: Chang, Lerng-Horng, Neihu Dist Taipei City 11493 (TW)
(74) Representative: Zeitler - Volpert - Kandlbinder

(57) **Abstract**

A modular expandable electronic device structure against intrusion of foreign object comprising: a case body (10) developed by a number of case covers (11) and at least a through hole (131) on one of the case covers (11); an external communication part (20) held in the case body (10) and comprising an external electric coupler (21); a sealing regulator (30) separated into two strut members (31, 32) positioned in the through hole (131) on the case cover (11) and assembled onto a retaining plate (33) and a sliding panel (34): the retaining plate (33) mounted and positioned on the case cover (11) is able to partially conceal the through hole (131); the sliding panel (34) slides on the strut members (31, 32); both the sliding panel (34) and the retaining plate (33) conceal the through hole (131) or the sliding panel (34) slides to partially expose the through hole (131) which corresponds to the external electric coupler (21). As such, the case body (10) in which electronic components are held has simple clear exterior and provides excellent protection.

## Description

### BACKGROUND OF THE INVENTION

### FIELD OF THE INVENTION

The present invention relates to an electronic device structure against intrusion of foreign object, particularly a modular expandable case body with simple clear exterior for flexible installation, stacking and positioning.

### DESCRIPTION OF THE RELATED ART

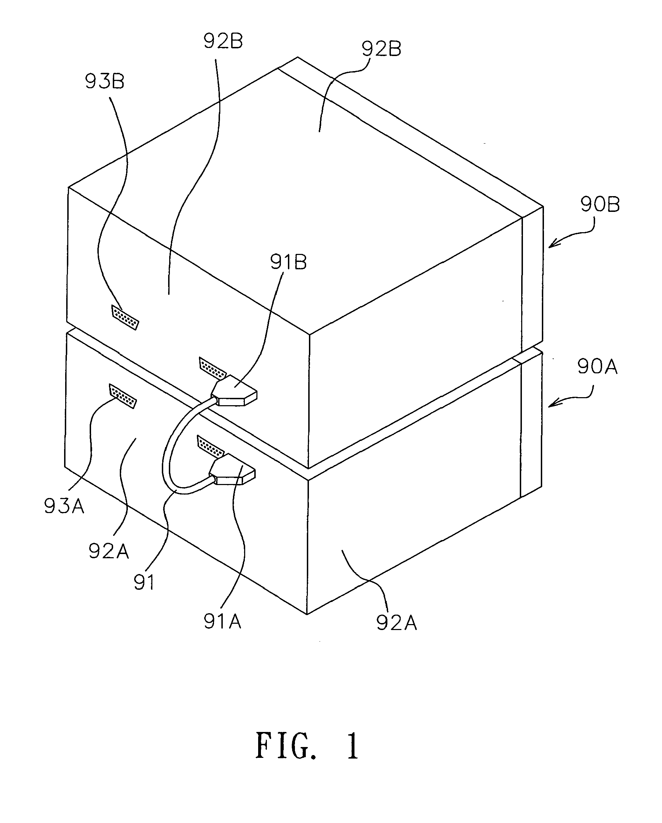

The situation that a number of electronic devices (e.g., computer) are connected to one another is a common issue. As shown in FIG. 1, electronic devices are connected according to the prior art which exemplifies two case bodies 90A, 90B vertically arranged: the case body 90A (90B) comprises a number of case covers 92A (92B) in which an electric connector 93A (93B) is designed on at least one of the case covers for connection between the electronic devices by a cable 91 with adapters 91 A, 91B at both ends electrically connected to the electric connector 93A on the case body 90A and the electric connector 93B on the case body 90B, respectively. However, the expansion case bodies 90A, 90B which are electrically connected by the cable 91 but short of one design for positioning in between usually slide past each other, pulling and loosing the cable 91, and resulting in failure of communication; in addition, the external cable 91 which may disarranges exterior of one computer system or cause failure of communication while loosen is not an ideal design.

Referring to another modular expansible structure technology in the prior art (R.O.C Patent document published as "No. 547687" in FIG. 2.) which provides a modular industrial computer case structure based on an expansion interface card and comprising a main case 10 and an expansion case 20. The main case 10 comprises a number of main case covers 11, one of which has (a) a recess 111 for accommodating a raised plug-in unit 121 on a motherboard 12 and (b) at least a slot 13 at one surface perpendicular to a side wall on which there is a screw hole 14 penetrated by a bolt-on member 141; the expansion case 20 is provided with (a) a raised binding groove 31 used to join the plug-in unit 121 on the motherboard 12 and (b) a protruding tenon 211 correspondingly joining the slot 13 opened on the main case 10 so that the plug-in unit 121 is precisely and securely coupled with the binding groove 31 with the tenon 211 joining the slot 13 as well as the bolt-on members 141 penetrating and engaging the pilot holes 2111 and the screw holes 14.

The above patent which is effective in electric connection between cases without a cable still has some drawbacks and is taken as an unideal design deserving to be further corrected, for example, (a) both the main case 10 and the expansion case 20 have no simple clear exterior because of the plug-in unit 121 and the binding groove 31 raising from the two cases, (b) electric connection may fail because the plug-in unit 121 of the main case 10 to which no expansion case 20 is connected is possibly damaged, and (c) assembly is time-consuming and troublesome when both the main case 10 and the expansion case 20 are connected and positioned by the slots 13 and the plug-in units 121 when the bolt-on members 141 penetrating the screw holes 14 and the pilot holes 2111 are screwed into the tenons 211. Against this background, it has become a critical issue to correct and get over drawbacks in assembling and positioning a modular expandable computer structure by persons skilled in the industry.

Accordingly, the inventor having considered imperfect structural design and other drawbacks of the prior art for a modular expandable electronic device structure and attempted to optimize a solution such as simple clear exterior, flexible assembly, and convenient stacking, parallel expansion and positioning has studied and developed the present invention for promoting development of the industry.

### SUMMARY OF THE INVENTION

The object of the present invention is to provide a modular expandable electronic device structure against intrusion of foreign object which has simple clear exterior but no protruding components and truly accommodates, protects and conceals all electronic components.

The other object of the present invention is to provide a modular expandable electronic device structure against intrusion of foreign object which is of service to assembly of case bodies in which electronic components are held by means of stacking or parallel expansion and is also characteristic of flexibility, efficiency and security.

To reach the above purposes, the present invention is based on technical measures comprising: an electronic device along with a case body developed by a number of case covers and comprising a through hole opened on at least one of the case covers; an external communication part held in the case body and comprising at least an external electric coupler corresponding to the through hole; a sealing regulator comprising at least a strut member which is positioned in the through hole on the case cover and assembled onto a retaining plate and a sliding panel: the retaining plate is fixed at the case cover and partially conceals the through hole; the sliding panel slides on the strut members; both the sliding panel and the retaining plate conceal the through hole or the sliding panel slides to expose the through hole partially and develop an external through hole which is opposite to the external electric coupler.

For technical features and effects in terms of the present disclosure completely understood and recognized, the preferred embodiments and accompanying drawings are thoroughly described hereinafter.

### DETAILED DESCRIPTION OF THE PREFERRED EMBODIMENTS

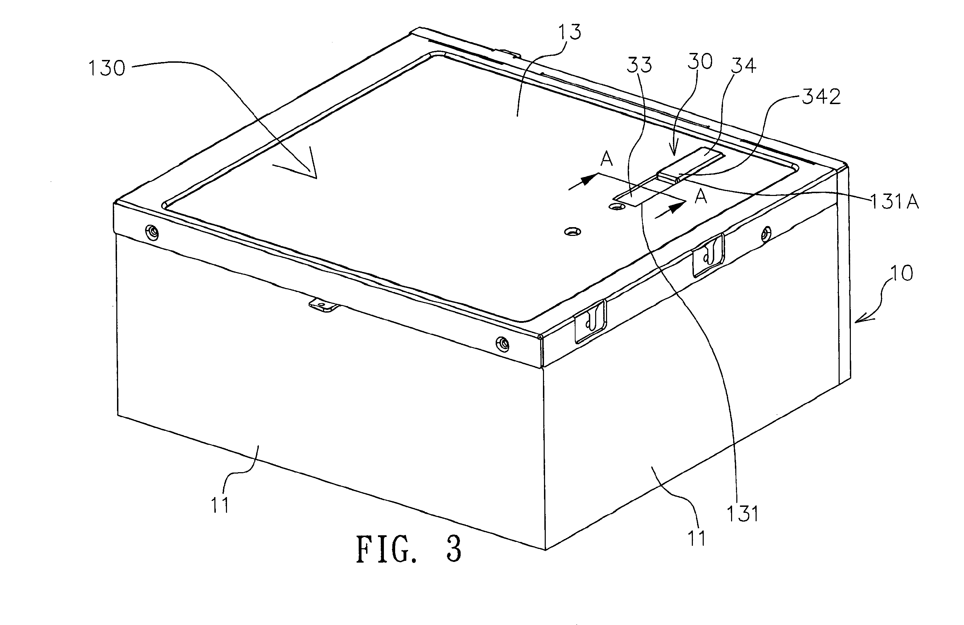

Referring to FIG. 3 through FIG. 5 which illustrate the present invention of a modular expandable electronic device structure against intrusion of foreign object comprises a case body 10, an external communication part 20, and sealing regulators 30: the case body 10 comprises four circumferential case covers 11, a bottom case cover 12, and a top case cover 13; and the top case cover 13 develops a concave embedding space 130 (based on their positions in figures) in order to accommodate a motherboard 14 on which there are a plurality of internal electronic components 15 installed such as CPU, expansion slot, expansion board, hard disc, etc. and the top case cover 13 which is disassembled from or assembled onto the case body 10 has a through hole 131 in place, including but not limited to a rectangular hole, and a pilot hole 132 beside the through hole 131.

The external communication part 20 comprises an external electric coupler 21 which is positioned on an expansion baseplate 22 inside the case body 10 and corresponds to the through hole 131.

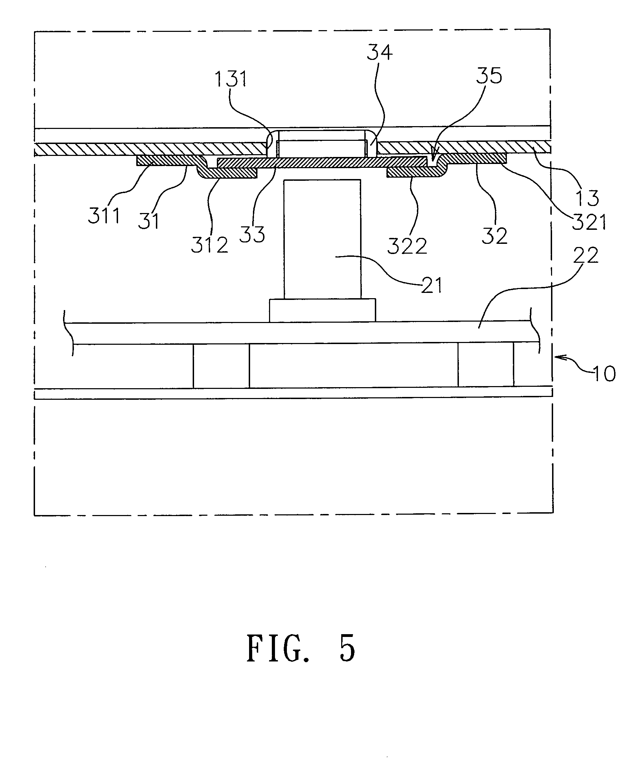

In the present invention, the sealing regulator 30 can be separated into two strut members 31, 32 (or support sheets), including but not limited to rectangular sheets, which are positioned under the through hole 131 on the top case cover 13 (inside the case body 10 in FIG. 3 through FIG. 5; similarly hereinafter) and have connection parts 311, 321 at outer upper positions and support parts 312, 322 at inner lower positions, respectively: the connection parts 311, 321 are connected to and positioned on the top case cover 13; the support parts 312, 322 develop a support accommodation space 35 (FIG. 5.). Both the strut members 31, 32 are assembled onto a retaining plate 33 and a sliding panel 34 at their upper (outer) positions: the retaining plate 33 on which there is a pilot hole 331 is fixed on the top case cover 13 by means of a screw member 133 penetrating the pilot hole 132; the sliding panel 34 comprises two lower sliding parts 341 at both sides and a higher hogback part 342 centrally; the retaining plate 33 and the sliding panel 34 are held in the support accommodation space 35 developed by the support parts 312, 322 and consequently conceal the through hole 131 after the retaining plate 33 and the sliding panel 34 are connected side by side; the sliding panel 34 which covers the through hole 131 is also opposite to an external through hole 131A (FIG. 3) and slides with respect to the through hole 131 (the strut members 31, 32) for exposure of the external through hole 131A.

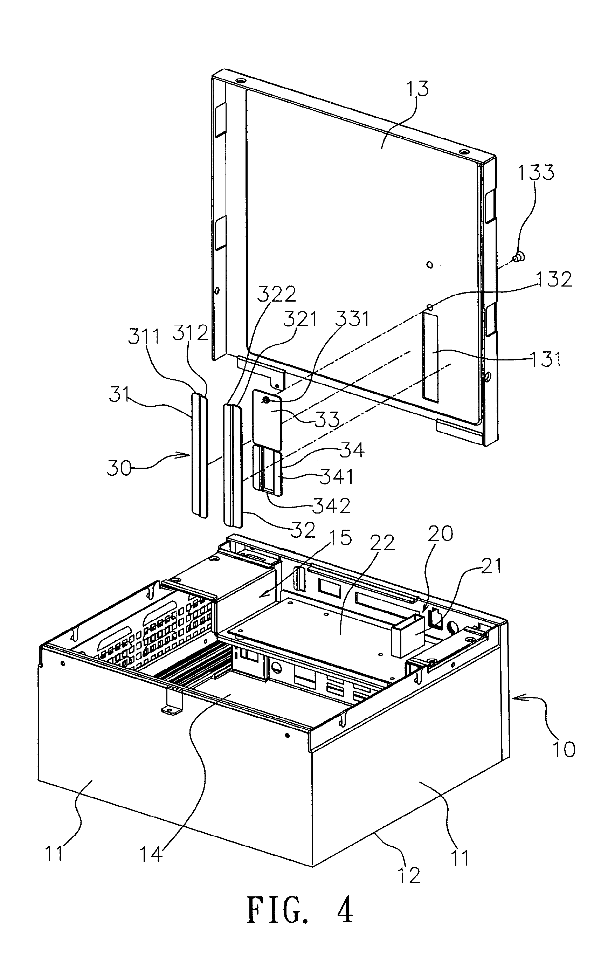

In a preferred embodiment, the external electric coupler 21 is situated at one position opposite to the external through hole 131A; the sliding panel 34 and the fixed retaining plate 33 slides could expose the external through hole 131A or conceal the through hole 131 (FIG. 3, 4), the through hole 131 and the corresponding sealing regulator 3 can be setup on either the top case cover 13 or any of the case covers 11 around the case body 10 for parallel expansion of a number of cases.

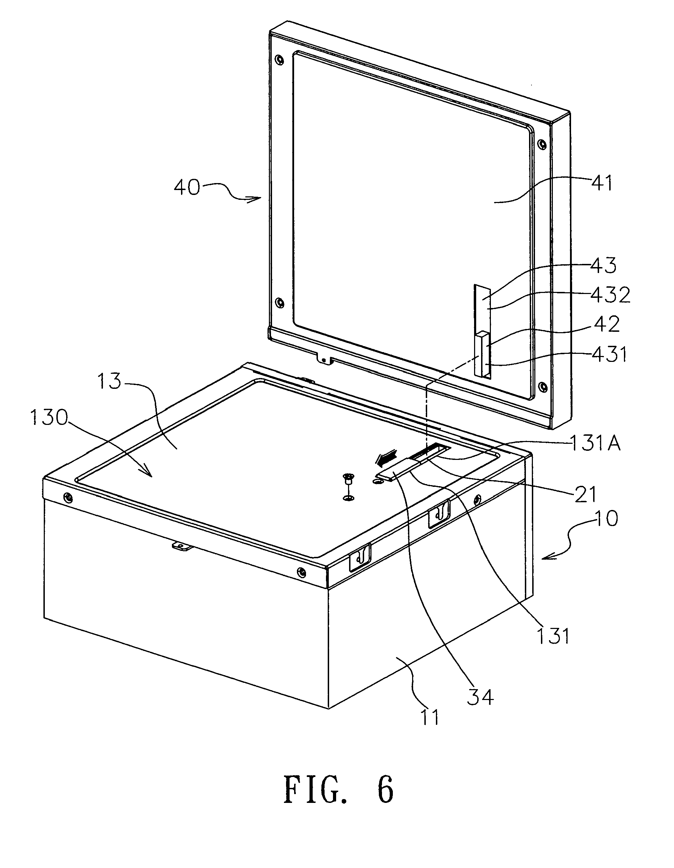

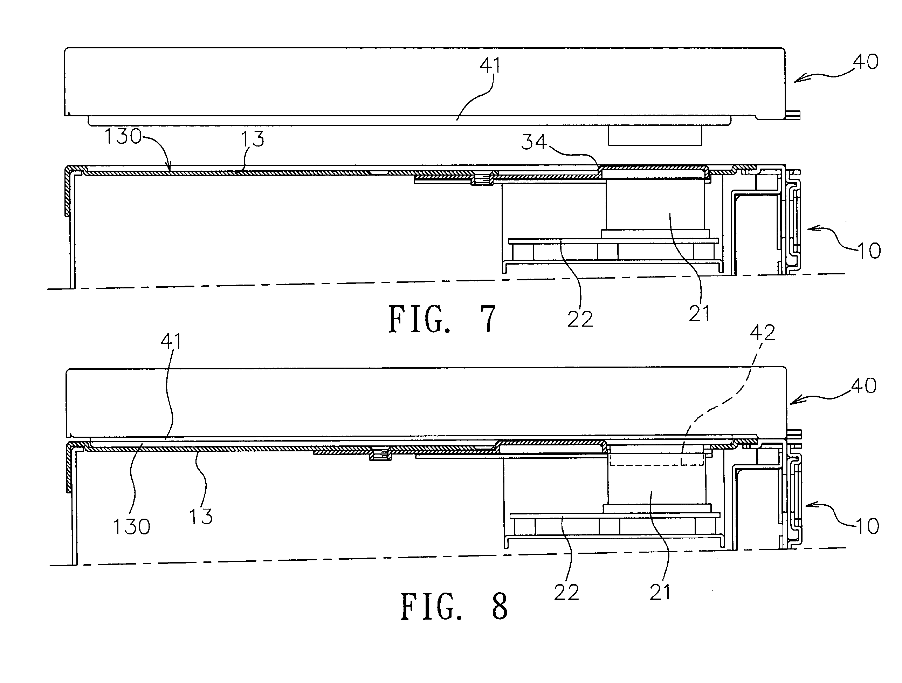

Referring to FIG. 6 through FIG. 8 which are exemplary illustrations of a modular expandable electronic device structure against intrusion of foreign object as one embodiment of the present invention, describing design of modular expandable electronic devices. In the embodiment, an expansion case body 40 (electronic expansion unit) is stacked on the case body 10 and provided with a raised abutting case cover 41 on which there is an abutting groove 43 corresponding to the through hole 131 on the case body 10 and containing an abutting electric coupler 42 at one side for electric connection to the electrical elements of the expansion case body 40. In a preferred embodiment, the abutting groove 43 develops a first abutting groove 431 and a second abutting groove 432: the first abutting groove 431 like a through hole is frequently used in holding the abutting electric coupler 42 which is exposed inside out in the raised abutting case cover 41; the second abutting groove 432 corresponds to and joins the hogback part 342 held in the through hole 131.

During assembly, the sliding panel 34 in the case body 10 slides to expose the external through hole 131A; next, the expansion case body 40 is stacked on the case body 10 with the abutting case cover 41 of the expansion case body 40 held in the embedding space 130 of the case body 10 for steady stacking and safe operation without slip, in the time the second groove 432 of the expansion case body 40 is corresponding to the hogback part 342 of the case body 10. Furthermore, the abutting electric coupler 42 is able to butt the external electric coupler 21 of the case body through the external through hole 131 A for electric connection between the expansion case body 40 and the case body 10; the second abutting groove 432 on the expansion case body 40 should correspond to and match the slid hogback part 342 for further expansion in addition to the case body 10. As shown hereinbefore, the through hole 131 of the case body 10, which corresponds to the external electric coupler 21, can be designed at any of the case covers 11 for parallel expansion of the expansion case body 40.

During modular expansion, the case body 10 with design of the external electric coupler 21 which is concealed or exposed has simple clear exterior but no protruding components and truly accommodates, protects and conceals all electronic components; the present invention which is of service to assembly of case bodies in which electronic components are held by means of stacking or parallel expansion and is also characteristic of flexibility, efficiency and security.

Therefore, the present invention significantly meets patentability and is applied for the patent. However, the above descriptions present preferred embodiments only which do not limit the scope of the present invention; any equivalent change or improvement based on shapes, structures, features and spirit mentioned in the present invention should be incorporated in claims of the present invention.

### BRIEF DESCRIPTION OF THE DRAWINGS

FIG. 1 is a schematic view illustrating expansion and connection of computers based on the prior art.

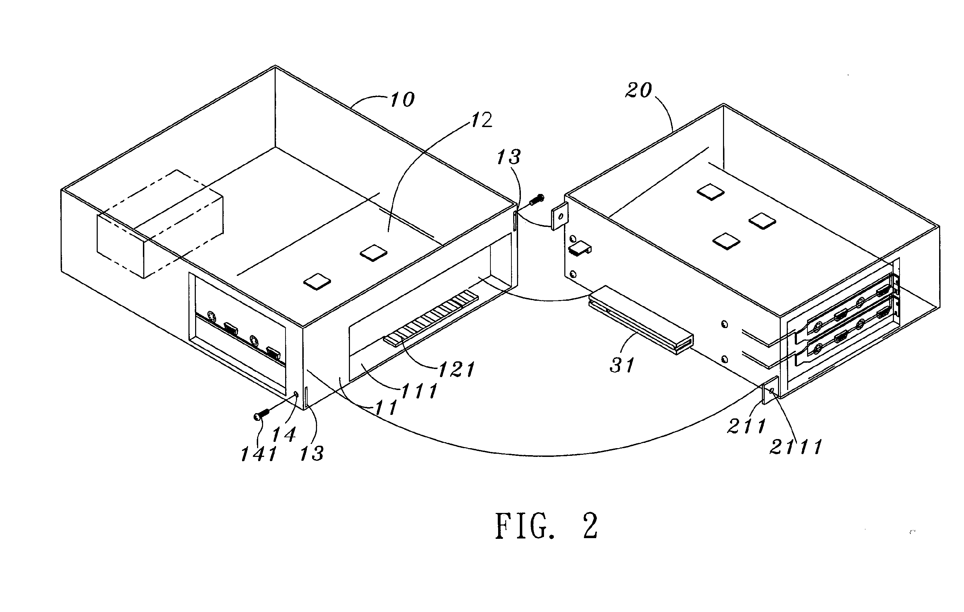

FIG. 2 is a further schematic view illustrating expansion and connection of computers based on the prior art.
FIG. 3 is a schematic perspective view of the present invention.
FIG. 4 is a schematic exploded view of the present invention.
FIG. 5 is a partial sectional view of the present invention in FIG. 3 (Section A-A).
FIG. 6 is a schematic exploded view illustrating the present invention in an embodiment.
FIG. 7 is a sectional and exploded view of the present invention in an embodiment.
FIG. 8 is a sectional view of the present invention assembled in an embodiment.

## Claims

1. A modular expandable electronic device structure against intrusion of foreign object, comprising:
A case body (10) comprising a number of case covers (12) and at least a through hole (131) at one of said case covers (12);
An external communication part (20) situated in said case body (10) and comprising at least an external electric coupler (21) which corresponds to said through hole (131);
A sealing regulator (30) comprising at least a strut member (31, 32) which is positioned in said through hole (131) on said case cover (12) and assembled onto both a retaining plate (33) and a sliding panel (34): said retaining plate (33) is fixed on said case cover (12) and partially conceals said through hole (131); said sliding panel (34) slides on said strut members (31, 32); both said sliding panel (34) and said retaining plate (33) conceal said through hole (131) or said sliding panel (34) slides to expose said through hole (131) partially and develop an external through hole (131A) which is opposite to said external electric coupler (21).

2. The modular expandable electronic device structure against intrusion of foreign object according to Claim 1, **characterized in that** said case cover (12) on which there is said through hole (131) is disassembled from or assembled onto said case body (10).

3. The modular expandable electronic device structure against intrusion of foreign object according to Claim 1, **characterized in that** said external communication part (20) is installed on an expansion baseplate (22) inside said case body (10).

4. The modular expandable electronic device structure against intrusion of foreign object according to Claim 1, **characterized in that** said sealing regulator (30) can be separated into two strut members (31, 32) which have connection parts (311, 321) at outer upper positions and support parts (312, 322) at inner lower positions, respectively: said two connection parts (311, 321) are connected to and positioned at said top case cover (13); said support parts (312, 322) develop a support accommodation space (35).

5. The modular expandable electronic device structure against intrusion of foreign object according to Claim 1, **characterized in that** said retaining plate (33) has a pilot hole (331) used to fix said retaining plate (33) on said case cover (12).

6. The modular expandable electronic device structure against intrusion of foreign object according to Claim 1, **characterized in that** said sliding panel (34) comprises two lower sliding parts (341) at both sides and a higher hogback part (342) centrally.

7. The modular expandable electronic device structure against intrusion of foreign object according to Claim 2, **characterized in that** at least one of said case covers (11) develops a concave embedding space (130).

8. The modular expandable electronic device structure against intrusion of foreign object according to Claim 1 further comprises an expansion case body (40) with an abutting case cover (41) on which there is a raised abutting electric coupler (42) corresponding to said external through hole (131A) and electrically connected to said expansion case body (40).

9. The modular expandable electronic device structure against intrusion of foreign object according to Claim 8, **characterized in that** said abutting electric coupler (42) is held in an abutting groove (43) which is opened on said abutting case cover (41).

10. The modular expandable electronic device structure against intrusion of foreign object according to Claim 9, **characterized in that** said abutting groove (43) comprises a first abutting groove (431) and a second abutting groove (432) for electric connection.

11. The modular expandable electronic device structure against intrusion of foreign object according to Claim 10, **characterized in that** said first abutting groove (431) and said second abutting (432) are through holes.

12. The modular expandable electronic device structure against intrusion of foreign object according to Claim 8, **characterized in that** said abutting case cover (41) is a slightly raised component.
